(19) Europäisches Patentamt
European Patent Office
Office européen des brevets

(11) **EP 2 717 343 B1**

(12) **EUROPÄISCHE PATENTSCHRIFT**

(45) Veröffentlichungstag und Bekanntmachung des Hinweises auf die Patenterteilung:
**24.09.2014 Patentblatt 2014/39**

(51) Int Cl.:
***H01L 41/00*** *(2013.01)*     *H01L 41/047* *(2006.01)*

(21) Anmeldenummer: **12187606.4**

(22) Anmeldetag: **08.10.2012**

(54) **Magnetoelektrischer Sensor und Verfahren zu seiner Herstellung**

Magneto-electric sensor and method for manufacturing the same

Capteur magnétoélectrique et son procédé de fabrication

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.04.2014 Patentblatt 2014/15**

(73) Patentinhaber: **Christian-Albrechts-Universität zu Kiel**
**24118 Kiel (DE)**

(72) Erfinder:
• **Piorra, André**
**24118 Kiel (DE)**
• **Quandt, Eckhard**
**24226 Heikendorf (DE)**

(74) Vertreter: **Hansen, Jochen**
**Hansen und Heeschen**
**Patentanwälte**
**Eisenbahnstrasse 5**
**21680 Stade (DE)**

(56) Entgegenhaltungen:
JP-A- 11 126 449     US-A1- 2007 252 593
US-A1- 2008 145 693     US-A1- 2011 077 663

EP 2 717 343 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen magnetoelektrischen Sensor zur Messung von Magnetfeldern umfassend einen Schichtenstapel aus einer magnetostriktiven Schicht, einer ferroelektrischen Schicht und einer elektrisch nicht-leitenden (i. F. dielektrischen) Trägerschicht.

Magnetoelektrische Komposite sind seit einigen Jahren ein Schwerpunkt im Forschungsgebiet der Sensorik mit dem Ziel der Messung sehr kleiner, üblicherweise zeitabhängiger magnetischer Felder. Magnetoelektrische Komposite bestehen aus einer magnetostriktiven und einer piezoelektrischen Phase. Zu den piezoelektrischen Materialien zählen auch die Ferroelektrika.

Ein magnetisches Feld H bewirkt eine Längenänderung der magnetostriktiven Phase, die über eine mechanische Kopplung auf das Piezoelektrikum übertragen wird und dort eine mechanische Zug- oder Schubspannung erzeugt. Durch die piezoelektrische Spannungskonstante g wird in dem piezoelektrischen Material eine dielektrische Polarisation hervorgerufen, die makroskopisch in einer messbaren magnetoelektrischen Spannung $U_{ME}$ resultiert. Hierbei ist die erzielbare elektrische Spannung $U_{ME}$ (i. F. auch ME-Spannung) direkt proportional zu dem piezomagnetischen Koeffizienten $d^m$, der piezoelektrischen Spannungskonstante g, der Kopplung der beiden Phasen k und der Schichtdicke z des piezoelektrischen Materials (Gleichung 1).

$$\frac{\Delta U_{ME}}{\Delta H} \propto d^m * k * g * z$$

$$(1)$$

Üblicherweise wird ein magnetoelektrisches Komposit in der Art eines einfachen Plattenkondensators ausgestaltet. Hierbei befindet sich das piezoelektrische Material (z.B. Aluminiumnitrid, AlN, Blei-Zirkonat-Titanat, PZT) als Dielektrikum zwischen zwei elektrisch leitenden Schichten, die als Elektroden fungieren. Gewöhnlich ist die magnetostriktive Phase als wenigstens eine der Elektroden ausgebildet, wenn ohnehin ein metallisches, magnetostriktives Material verwendet werden soll. Der Vorteil von metallischen Materialien liegt in der Ausprägung des magnetostriktiven Effekts. Die höchsten piezomagnetischen Koeffizienten sind bei metallischen, amorphen Materialien, wie Metglas® (FeCoSiB) zu beobachten.

Es ist ferner bekannt, magnetoelektrische Komposite als Dünnschicht-Komposite, die in der Regel als weitere Komponenten Träger für die Funktionsschichten aufweisen, auszugestalten. Die Verwendung solcher Komposite ist bei kleinen geforderten Baugrößen und zur Herstellung von Sensorarrays von Vorteil. Ein weiterer Vorteil ist dabei im Verzicht auf Klebetechnik zu sehen, die ansonsten übliche Verbindungstechnik bei Kompaktmaterialien. Mit der Klebeschicht entfällt eine Schicht an der Grenzfläche zwischen den Phasen, die die magnetostriktive Längenänderung z.T. absorbieren könnte. Dadurch wird u.a. auch die Reproduzierbarkeit von Dünnschicht-ME-Sensoren verbessert.

Dünnschicht-ME-Sensoren werden oft als einseitig eingespannte Biegebalken aufgebaut. Dabei zeigt sich, dass in Resonanz betriebene Biegebalken durch hohe Güten sehr hohe magnetoelektrische Spannungen aufweisen (H. Greve, E. Woltermann, H.-J. Quenzer, B. Wagner, and E. Quandt, "Giant magnetoelectric coefficients in (Fe90Co10)78Si12B10-AlN thin film composites", Applied Physics Letters, vol. 96, 2010, p. 182501).

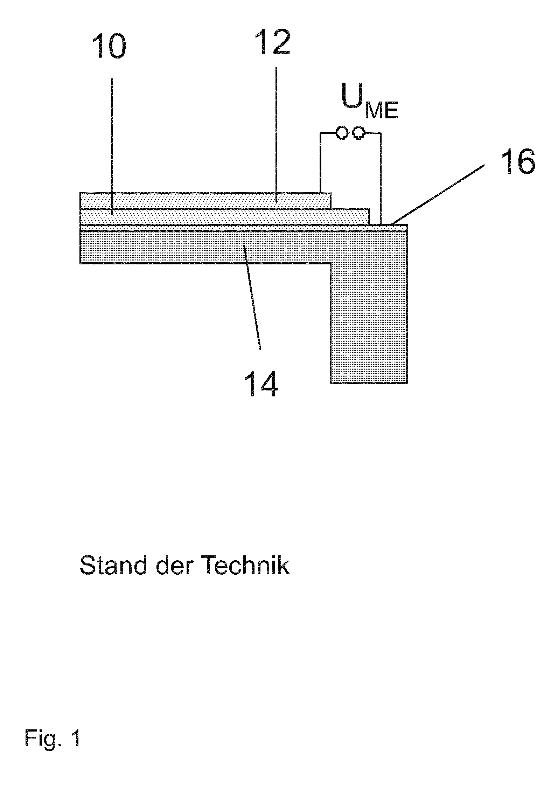

In Fig. 1 ist ein ME-Biegebalkensensor nach dem Stand der Technik skizziert. Auf einem einseitig fixierten Substratstreifen (14) sind zunächst eine Unterelektrode (16), darauf eine piezoelektrische Schicht (10) und wiederum darauf eine metallische magnetostriktive Schicht (12) angeordnet. Die ME-Spannung $U_{ME}$ wird wie eingezeichnet zwischen Unterelektrode (16) und magnetostriktiver Schicht (12) abgegriffen.

Die Herstellung von Biegebalkensensoren nach Fig. 1 erfolgt mit Methoden der Mikrosystemtechnik. Typische Substrate (14) sind Siliziumwafer, auf die einzelne Schichten mit bekannten Verfahren wie Kathodenzerstäubung (Sputtern) oder Aufdampfen (physical vapour deposition, PVD) oder einem Sol-Gel-Verfahren aufgebracht werden. Die beschichteten Wafer werden gewöhnlich lithographisch strukturiert, woraufhin sich dann eine Vereinzelung der eigentlichen Biegebalken anschließt.

Bei Dünnschicht-ME-Sensoren bildet das Substrat (14) einen integralen Bestandteil des im Oberbegriff genannten Schichtenstapels, da die Funktionsschichten (ferroelektrisch, magnetostriktiv) (10, 12) aufgrund ihrer geringen Dicke nicht freitragend sein können. Die im Oberbegriff genannte Trägerschicht kann mit dem Substrat (14) identifiziert werden.

Wie bereits erläutert ist das Verhältnis der messbaren ME-Spannung zur anregenden magnetischen Feldstärke der Schichtdicke des Piezoelektrikums bzw. dem Abstand der Elektroden über der piezoelektrischen Phase proportional. Folglich kann man die ME-Spannung, die durch eine vorbestimmte Magnetfeldstärke hervorgerufen wird, einfach dadurch steigern, dass man die Schichtdicke des Piezoelektrikums erhöht.

Bezogen auf Dünnschicht-ME-Sensoren sind diesem Vorgehen aber mit den üblichen Methoden der Mikrosystemtechnik Grenzen gesetzt. Limitierungen ergeben sich u.a. aus den Eigenspannungen und der geringen Abscheiderate.

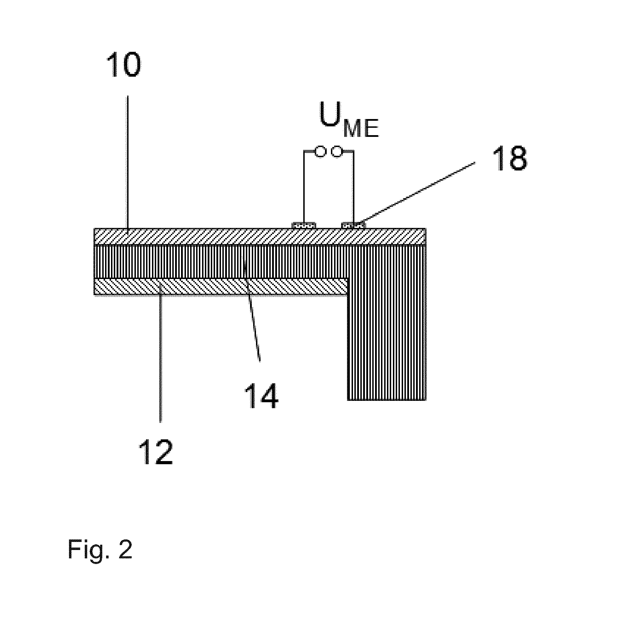

Eine Alternative ist der Druckschrift US 2008/0193780 A1 zu entnehmen. Ein ME-Sensor nach Bauart eines Layer Stack wird vorgeschlagen, dessen Kern eine Anordnung parallel verlaufender ferroelektrischer Fasern (dort z.B. aus Blei-Zirkonat-Titanat, PZT) in einem Matrixepoxid bildet. Auf beiden Flachseiten des so gebildeten, schichtförmigen ferroelektrischen Komposits wird je eine Interdigitalelektrode (IDT), eine dünne Polymerfolie als elektrischer Isolator (s. dort Fig.2, 28 A und 28 B sowie Absatz 0057 "insulating field") und eine metallische magnetostriktive Schicht (Metglas®) angeordnet. Die Anordnung der Elektroden erfolgt dabei derart, dass Elektrodenfinger mit gleicher Polarität direkt übereinander zu liegen kommen. Durch Polung kann der Polarisationsvektor des ferroelektrischen Komposits entlang der Faserrichtung (longitudinal) zwischen den benachbarten Elektrodenfingern entgegengesetzter Polarität räumlich alternierend ausgerichtet werden. Die Druckschrift spricht von "push-pull units" und verweist dabei auf die Ausschnittvergrößerung 200 der dortigen Fig. 2.

Der Signalabgriff über die IDT gestattet prinzipiell, durch die Wahl des Fingerabstandes der Elektroden festzulegen, wie groß die ME-Spannung für ein vorgegebenes Magnetfeld ausfällt. Im Grundsatz gilt: je größer der Fingerabstand, desto größer die ME-Spannung.

Zur Vermeidung von Missverständnissen soll hier und im Folgenden klargestellt sein, dass der Fingerabstand einer Elektrodenanordnung den kleinsten Abstand zweier nicht miteinander kontaktierter Elektroden bezeichnet oder auch alternativ die Länge derjenigen Strecke, über der bei Anlegen einer vorbestimmten Spannung an die Elektroden die größte elektrische Feldstärke vorliegt. Speziell betreffend Interdigitalelektroden sind die ineinandergreifenden Finger der Elektroden und mithin der überall gleichermaßen vorliegende Fingerabstand dem Fachmann auch als Begriffe geläufig.

Der ME-Sensor nach der US 2008/0193780 A1 kann kaum als Dünnschicht-ME-Sensor bezeichnet werden, schon weil die Dicke des ferroelektrischen Komposits mindestens der Dicke der ferroelektrischen Fasern entsprechen muss, die mit 100 bis 350 $\mu$m angegeben werden. Anscheinend ist die Kompositplatte freitragend, und sie wird beidseitig mit einer Polymerfolie bedeckt, die allem Anschein nach bereits je ein Paar Interdigitalelektroden trägt. Die beidseitige Kontaktierung dient vermutlich der Erzeugung einer homogeneren Feldverteilung innerhalb der dicken Kompositplatte während der notwendigen elektrischen Polung. Das magnetostriktive Material, das mit einer Schichtdicke um 25 $\mu$m auf die Polymerfolie aufzubringen ist, darf dort beim Auftragen keine hohen Temperaturen erzeugen oder diesen ausgesetzt werden, da sonst das Polymer Schaden nehmen könnte. Insgesamt erscheint die Herstellung des Sensors der US 2008/0193780 A1 problematisch oder zumindest aufwendig und nicht kompatibel mit den bewährten Methoden der Massenfertigung.

Aus der US 2007/0252593 A1 geht ebenfalls eine Hybridstruktur bestehend aus einer magnetostriktiven und einer piezoelektrischen Dünnschicht hervor, die entweder als Doppelschicht (piezoelektrische Dünnschicht in Kontakt mit magnetostriktiver Dünnschicht) oder als Dreifachschicht (piezoelektrische Dünnschicht zwischen zwei magnetostriktiven Dünnschichten) ausgeführt ist.

Will man den Gedanken des ME-Spannungsabgriffs entlang der Ausdehnung der ferroelektrischen Schicht aufgreifen und auf ME-Sensoren, insbesondere auf Dünnschicht-ME-Sensoren, die mit den gängigen Methoden der Mikrosystemtechnik herstellbar sind, übertragen, dann steht man mehreren Problemen gegenüber.

Die typische ferroelektrische Schicht eines ME-Sensors ist keramisch und wird gewöhnlich in Form eines Precursors, welcher auch organisches Material enthält (z.B. bei Sol-Gel-Verfahren oder Siebdruck), auf ein Substrat aufgetragen. In einer Wärmebehandlung bei Temperaturen über 500 °C wird diese Schicht pyrolisiert und kristallisiert. Die Herstellung der ferroelektrischen Schicht kann alternativ durch Kathodenzerstäubung oder gepulste Laserabscheidung erfolgen. Aber auch in diesen Fällen erfolgt die Abscheidung bei höheren Temperaturen, und es bedarf einer anschließenden Wärmebehandlung über 500°C zur Kristallisation.

Das Ersetzen der herkömmlichen Unterelektrode durch eine Elektrode, die zum Spannungsabgriff entlang der Schichtausdehnung ausgebildet ist, scheidet aus, weil man damit rechnen muss, dass die Kristallisation des Ferroelektrikums durch die Anwesenheit eines strukturierten Elektrodenlayers (z.B. aus Edelmetall Platin oder Gold) gestört wird. Um eine solche Elektrode aber nach der Kristallisation des Ferroelektrikums auf der ferroelektrischen Schicht anordnen zu können, muss diese eine freiliegende Außenfläche aufweisen.

Dies legt auf den ersten Blick nahe, die Reihenfolge der Schichtanordnung umzukehren, d.h. auf das Substrat wird zuerst das magnetostriktive Material aufgebracht und auf dieses wiederum das Ferroelektrikum. Man kann dies auch als invertierte Schichtfolge bezeichnen.

Doch das magnetostriktive Material benötigt eine magnetische Anisotropie, um überhaupt Magnetostriktionseigenschaften zu besitzen. Beispielsweise kann eine magnetische Anisotropie hervorgerufen werden, wenn das magnetostriktive Material unter kontrollierten Bedingungen in einem Magnetfeld abgeschieden oder nachträglich in einem Magnetfeld wärmebehandelt wird. Eine andere Möglichkeit geht aus der - nicht vorveröffentlichten - EP 11 171 354.1 (veröffentlicht als EP 2 538 235 A1) hervor.

Danach wird die magnetostriktive Schicht als ein Multilagenschichtsystem aus abwechselnden ferromagnetischen (FM) und antiferromagnetischen (AFM) Lagen hergestellt, in dem sich ein Exchange Bias ausbilden kann. Die einstellbare Ausrichtung der AFM-Lagen "pinnt" die magnetischen Dipole der FM-Lagen derart, dass sich entlang einer bestimmbaren Richtung in den Schichten ein hoher piezomagnetischer Koeffizient auch in Abwesenheit des ansonsten zur Einrichtung eines geeigneten Arbeitspunktes erforderlichen Bias-Magnetfeldes einstellt. Die Verwendung der Multilagenschichtsysteme nach der EP 11 171 354.1 wird als sehr vorteilhaft zur Fertigung von Sensor-Arrays angesehen, da die magnetische Wechselwirkung zwischen den einzelnen Sensoren sehr klein ist und sich diese somit nicht gegenseitig stören.

Allerdings verbietet sich für die vorgenannten magnetostriktiven Schichten ganz klar, diese Schichten den zur Kristallisation eines keramischen Ferroelektrikums nötigen Temperaturen auszusetzen, weil sie dadurch permanenten Schaden nähmen. Beispielsweise könnte bei der Verwendung von Multilagen durch Diffusion der Schichtaufbau zerstört werden oder bei amorphen Schichten eine Kristallisation bei erhöhter Temperatur erfolgen.

Sogar wenn der Aufbau eines ME-Sensors mit invertierter Schichtfolge (s. o.) gelingt, hat man spätestens bei der elektrischen Polung der ferroelektrischen Schicht mit einer Interdigitalelektrode oder dergleichen das Problem, dass ein deutlich vergrößerter Fingerabstand der Elektroden auch das Anlegen einer entsprechend erhöhten Spannung erfordert, damit die notwendige elektrische Feldstärke zwischen $10^6$ und $10^7$ V/m erreicht wird. Bei Dünnschicht-ME-Sensoren mit Schichtdicken im Bereich weniger Mikrometer ist dies äußerst problematisch, denn der Elektrodenanordnung auf der einen Seite der ferroelektrischen Schicht liegt in geringem Abstand das magnetostriktive Material gegenüber, das gewöhnlich metallisch ist und somit das elektrische Feld stark verzerrt. Eine gut reproduzierbare oder gar gleichmäßige Polung des Ferroelektrikums ist so kaum zu erreichen. Man muss vielmehr sogar mit einem elektrischen Durchbruch des Ferroelektrikums rechnen, wenn die Spannung zu groß gewählt wird und daher über die magnetostriktive Schicht letztlich ein Stromkreis geschlossen werden kann.

Vor diesem Hintergrund stellt sich die Erfindung die Aufgabe, einen neuen Typ ME-Sensor vorzuschlagen, der den Abgriff einer deutlich höheren ME-Spannung als ein herkömmlicher Biegebalkensensor ermöglicht und zugleich mit den konventionellen Beschichtungsverfahren herstellbar ist.

Die Aufgabe wird gelöst durch einen magnetoelektrischen Sensor umfassend einen Schichtenstapel aus einer magnetostriktiven Schicht, einer ferroelektrischen Schicht und einer elektrisch nicht-leitenden Trägerschicht, dadurch gekennzeichnet, dass die Trägerschicht dicker als die ferroelektrische Schicht und zwischen der magnetostriktiven und der ferroelektrischen Schicht angeordnet ist, und dass ferner eine Elektrodenanordnung ausgebildet zum Signalspannungsabgriff entlang der Schichtenausdehnung auf der ferroelektrischen Schicht angeordnet ist, wobei der Fingerabstand der Elektrodenanordnung größer ist als die Dicke der ferroelektrischen Schicht.

Die Unteransprüche geben vorteilhafte Ausgestaltungen des ME-Sensors gemäß Anspruch 1 an oder sind auf ein Herstellverfahren gerichtet.

Der Grundgedanke der Erfindung besteht darin, die beiden Funktionsschichten des ME-Sensors räumlich voneinander zu trennen, indem eine Schicht aus dielektrischem Material zwischen beiden angeordnet wird. Der Abstand der Funktionsschichten soll dabei größer, vorzugsweise vielfach größer, als die Dicke der ferroelektrischen Schicht sein. Die dielektrische Schicht zwischen den Funktionsschichten hat somit die Zwecke sowohl der elektrischen Isolierung als auch der Abstandshaltung. Die Funktionsschichten des neuen ME-Sensors sind beides Außenschichten des Schichtenstapels. Es wird für das neue ME-Sensordesign der Begriff Trennschicht-ME-Sensor ("separator ME sensor", SMES) vorgeschlagen und im Weiteren verwendet.

Der bislang gängigen Auffassung, ein magnetoelektrisches Komposit könne nur dann gute ME-Sensor-Eigenschaften zeigen, wenn die magnetostriktive und die piezoelektrische Phase in sehr enger Nachbarschaft oder sogar direkt aufeinander angeordnet werden, wird hiermit widersprochen. Wie Experimente zeigen, lässt sich die Längenänderung der magnetostriktiven Schicht, die entlang der Schichtausdehnung erfolgen soll, ohne weiteres auch durch dicke Trennschichten hindurch auf die ferroelektrische Schicht übertragen.

Man kann die magnetostriktive Schicht als Emitter einer mechanischen Scherwelle (kontinuierlich oder gepulst) ansehen, die durch die Trennschicht propagiert und unter Ausbildung einer elektrischen Polarisation in der ferroelektrischen Schicht absorbiert wird. Zwar ist dabei mit Dämpfungsverlusten zu rechnen, aber die transportierte mechanische Energie reicht immer noch aus, um im Zusammenspiel mit dem nunmehr vergrößerten Fingerabstand der Elektrodenanordnung zum ME-Spannungsabgriff ein deutlich stärkeres Signal für dieselbe magnetische Feldstärke zu erhalten als im Stand der Technik.

Bekanntlich sind hohe mechanische Impedanzkontraste an Schichtgrenzen für eine mechanische Energietransmission nachteilig. Die dielektrische Trennschicht sollte deshalb hinsichtlich ihrer Massendichte und Schallgeschwindigkeit den Funktionsschichten zumindest ähnlich sein. Vorzugsweise weist sie einen nicht zu kleinen Elastizitätsmodul auf. Insofern kommen praktisch alle Polymere als Trennschichtmaterial nicht in Frage. Dies ist auch ein wichtiger Unterschied zur Lehre der US 2008/0193780 A1, die eine dünne Polymerfolie zwischen den Funktionsschichten anordnet, um IDT zu tragen und elektrisch zu isolieren. Über die Effizienz des mechanischen Energietransports durch diese Folie legt die Druckschrift keine Rechenschaft ab, obwohl dies nicht als selbstverständlich erscheint. Polymere sind als Träger eines keramischen Ferroelektrikums ohnehin ungeeignet, weil sie die Kristallisierung der Schicht nicht überstehen würden. Der Elastizitätsmodul des Trennschichtmaterials sollte bevorzugt größer als 20 GPa sein.

Günstigerweise sind herkömmliche Substrate, auf denen Funktionsschichten für ME-Sensoren abgeschieden werden, bestens als dielektrische Trennschichten geeignet. Vorzugsweise bestehen diese Substrate aus Glas, insbesondere Siliziumdioxid, einer Keramik (z.B. Aluminiumoxid, $Al_2O_3$) oder aus einem Halbleiter, etwa einem Sliziumwafer. Beispielsweise beträgt der Elastizitätsmodul von Silizium 107 GPa, der von $SiO_2$ beträgt 94 GPa.

Es ist daher für die Herstellung von Trennschicht-ME-Sensoren gar nicht erforderlich, eigens eine Trennschicht herzustellen. Vielmehr kann man ein herkömmliches Substrat einfach auf beiden Flachseiten mit je einer der beiden Funktionsschichten beschichten, so dass das Substrat selbst die Trennschicht darstellt. Die Dicke des Substrats ist dabei vorbekannt und i. a. sehr viel größer als die Dicke einer der Funktionsschichten. Sie beträgt üblich zwischen etwa 50 und 500 μm, vorzugsweise zwischen 100 und 200 μm. Die Dicke der Funktionsschichten liegt gewöhnlich eine Größenordnung darunter.

Auf die mit dem Ferroelektrikum, vorzugsweise Blei-Zitkonat-Titanat (PZT), beschichteten Flachseite des Substrats wird eine Elektrodenanordnung zum Spannungsabgriff entlang der Schichtenausdehnung aufgebracht, deren Fingerabstand größer als die Dicke der ferroelektrischen Schicht, vorzugsweise sogar größer als die Dicke der Trennschicht ist. Der Fingerabstand der Elektroden ist somit größer, vorzugsweise sogar um wenigstens eine Größenordnung größer, als beim Biegebalkensensor nach dem Stand der Technik, wo die Elektroden nur genau durch die ferroelektrische Schichtdicke beabstandet sind.

Im Prinzip ist der einrichtbare Fingerabstand nach oben nur durch die Abmessungen des fertigen Sensors beschränkt. Allerdings erreicht man bei Fingerabständen im Millimeterbereich bereits die Notwendigkeit, die Polung des Ferroelektrikums mit Kilovolt-Spannungen vorzunehmen. Normalerweise wird man dies im Ölbad tun, damit sich keine Lichtbögen durch die Luft ausbilden können. Die magnetostriktive Schicht, die bevorzugt aus einem amorphen magnetischen Material gebildet ist und metallische Leitfähigkeit aufweist, wird noch vor der Polung auf der zweiten Flachseite des Substrats angeordnet worden sein, weil die Einrichtung ihrer magnetischen Anisotropie eine Temperaturbehandlung im Magnetfeld ("field annealing") um typisch 250-350 °C verlangt. Die elektrische Polung wiederum erfordert Temperaturen unterhalb der Curie-Temperatur des Ferroelektrikums, so dass sie in der thermischen Abfolge der Sensorherstellung den letzten Schritt bilden muss. Bei der Polung befindet sich somit bereits ein Leiter auf der anderen Seite des Substrats (der Trennschicht), der das Feld dort kollabieren lässt. Es fällt folglich auch ein Anteil der Polungsspannung über der dielektrischen Trennschicht ab, und dieser Anteil darf nicht zu einem elektrischen Durchschlag führen. Erfreulicherweise sind die Durchschlagsfeldstärken für die gängigen Substrate aber sehr hoch, beispielsweise um etwa 30 MV/m für Silizium und bis zu 1 GV/m für $SiO_2$.

Es ist problemlos möglich, Trennschicht-ME-Sensoren herzustellen, die auf der ferroelektrischen Schicht eine zum Signalspannungsabgriff ausgebildete Elektrodenanordnung mit Fingerabständen im Bereich einiger Millimeter aufweisen, wenn die zwischen den Funktionsschichten befindliche dielektrische Trennschicht 100 μm oder mehr dick ist.

Nachfolgend wird die Erfindung anhand der beiliegenden Zeichnungen und eines Ausführungsbeispiels näher beschrieben.

Darin zeigen:

Fig. 1    Schematische Darstellung eines magnetoelektrischen Biegebalkensensors im Plattenkondensatordesign nach dem Stand der Technik;

Fig. 2    Schematische Darstellung eines magnetoelektrischen Biegebalkensensors als Trennschicht-ME-Sensor;

Fig. 3    Messkurven zur ME-Spannung der Biegebalken im Resonanzfall für den Trennschicht-ME-Sensor (Fig. 2, $f_R$ ≈ 1100 Hz) und den Sensor nach dem Stand der Technik (Fig. 1, $f_R$ ≈ 2390 Hz).

In Fig. 1 ist die schematische Darstellung eines Biegebalkensensors nach dem Stand der Technik zu sehen, die bereits weiter oben erläutert wurde. Der Trennschicht-ME-Sensor ist zum Vergleich in Fig. 2 skizziert. Die ferroelektrische Schicht (10) und die magnetostriktive Schicht (12) liegen hier auf gegenüberliegenden Flachseiten desselben Substrats (14). Das Substratmaterial bildet die Trennschicht (14), die in Fig. 2 nicht maßstabsgerecht gezeichnet ist. Tatsächlich ist die Trennschicht (14) typisch um eine Größenordnung dicker als jede der Funktionsschichten (10, 12). Die Elektrodenanordnung (18) zum Abgriff der ME-Spannung ist nur auf einer Außenfläche - auf der Oberseite der ferroelektrischen Schicht (10) - angeordnet und misst elektrische Spannungen, die entlang der Schichtenausdehnung entstehen. Diese Spannungen werden im Ferroelektrikum (10) erzeugt, wenn sich in der magnetostriktiven Schicht (12) durch ein entlang der Schicht wirkendes Magnetfeld eine Längenänderung einstellt, die sich sodann auf die Trennschicht (14) und auf die ferroelektrische Schicht (12) überträgt.

Ein Verfahren zur Herstellung eines Trennschicht-ME-Sensors kann mit den folgenden Schritten durchgeführt werden:

1. Aufbringen eines eine ferroelektrische Schicht (10) bildenden Materials (z.B. Aufschleudern eines Sol-Gel-Precursors oder Kathodenzerstäubung eines Ferroelektrikums) auf die erste Flachseite eines dielektrischen Substrats (14),

2. Kristallisation des Materials bei Temperaturen über 500°C unter Bildung einer ferroelektrischen Schicht (10), deren Dicke kleiner ist als die vorbekannte Dicke des Substrats (14),

3. Aufbringen einer Elektrodenanordnung (18) (z.B. durch Sputtern von Platin unter Nutzung einer lithographischen Maskierung) ausgebildet zum Signalspannungsabgriff entlang der Schichtenausdehnung auf die ferroelektrische Schicht (10), wobei der Fingerabstand größer ist als die Dicke der ferroelektrischen Schicht (10),

4. Aufbringen einer magnetostriktiven Schicht (12) auf die zweite Flachseite des Substrats (14),

5. Magnetische Polung der magnetostriktiven Schicht (12) bei Temperaturen unter 500°C ("field annealing") und

6. Alternierende elektrische Polung der ferroelektrischen Schicht (10) entlang der Schichtausdehnung bei einer Temperatur unterhalb der Curie-Temperatur der ferroelektrischen Schicht (10).

Unter der alternierenden elektrischen Polung ist dabei zu verstehen, dass am Ende des Polungsvorgangs zwischen je zwei benachbarten Elektrodenfingern unterschiedlicher Polarität Polarisationsvektoren in der ferroelektrischen Schichtebene erzeugt worden sind, die abwechselnd in entgegengesetzte (alternierende) Richtungen zeigen (vgl. "push-pull units", US 2008/0193780 A1).

Das vorbeschriebene Verfahren weist drei Wärmebehandlungen in den Schritten 2, 5 und 6 auf. Es ist dabei wichtig, dass die jeweiligen Maximaltemperaturen in absteigender Reihenfolge durchlaufen werden. Die Schritte 4 und 5 lassen sich auch gleichzeitig durchführen, was dem Fachmann bekannt ist.

Ein Trennschicht-ME-Sensor ist als Ausführungsbeispiel wie folgt herstellbar:

Als Substrat wird beispielsweise ein Siliziumwafer (525 $\mu$m dick) mit einer thermisch oxidierten Siliziumoxidschicht verwendet. Auf die Oxidschicht wird zuerst eine Zirkondioxidschicht als Diffusionsbarriere und Keimstartschicht und danach eine PZT-Schicht jeweils mittels des Sol-Gel Verfahrens aufgebracht. Auf die bei etwa 700°C kristallisierte PZT-Schicht (Dicke 1-2 $\mu$m) wird ein Paar konventioneller Interdigitalelektroden (z.B. hier mit Fingerabstand 5-20 $\mu$m) mittels Photolithographie und anschließende Kathodenzerstäubung von Gold aufgebracht. Danach wird das Substrat auf eine Restdicke von ca. 150-200 $\mu$m mechanisch durch Schleifen und Polieren der Substratrückseite gedünnt. Auf diese polierte, sehr glatte Rückseite wird die magnetostriktive Schicht Metglas® (FeCoSiB) (Dicke ca. 4 $\mu$m) durch Kathodenzerstäubung aufgebracht. Schließlich werden die Balken durch Sägen vereinzelt.

Zum Vergleich wird ferner ein herkömmlicher Biegebalkensensor (wie in Fig. 1) im Plattenkondensatordesign aus denselben Materialien erzeugt. In beiden Fällen werden die magnetostriktiven Schichten nach dem Aufbringen magnetisch gepolt bei Temperaturen deutlich unterhalb 500°C, typisch im Temperaturintervall zwischen 250°C und 350°C, zur Einrichtung einer magnetischen Anisotropie.

Bevor die Balken als magnetoelektrische Sensoren nutzbar sind, muss eine elektrische Polung der ferroelektrischen PZT - Schicht erfolgen. Hierbei wird der Schichtverbund auf ca. 140 °C erwärmt und dabei in beiden Fällen ein elektrisches Feld von 10 MV/m (z.B. mit einer Spannung von 200 V bei 20 $\mu$m Fingerabstand für den Trennschicht-ME-Sensor bzw. mit etwa 25 V bei 2,5 $\mu$m PZT-Schichtdicke für den Biegebalkensensor im Plattenkondensatordesign) angelegt. Nach 15 Minuten bei konstanter Temperatur erfolgt die Abkühlung auf Raumtemperatur. Auch hierbei bleibt das elektrische Feld angelegt. Nach dem Polungsschritt sind die Sensoren nutzbar.

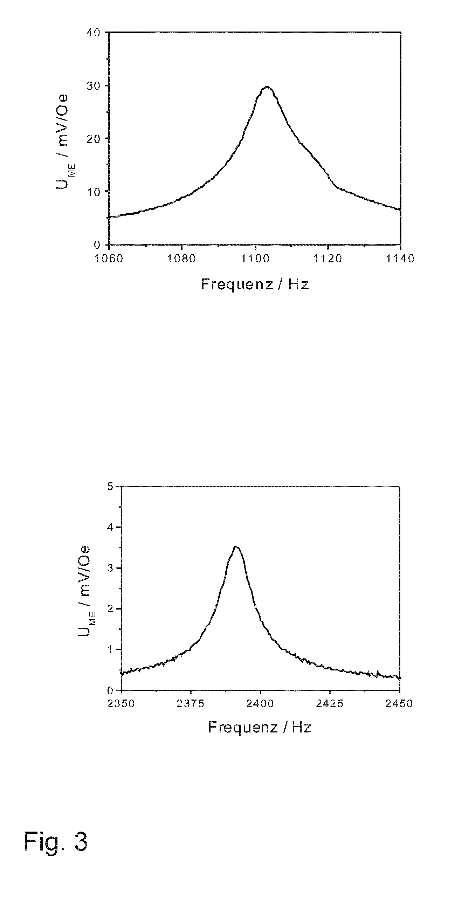

Fig. 3 zeigt die magnetoelektrische Spannungsausgabe der Sensoren, wenn ein zu messendes Magnetfeld mit Amplitude 1 Oe und einer Frequenz im Bereich der mechanischen Resonanzfrequenzen der Biegebalken - die sich aufbaubedingt hier unterscheiden - angelegt wird. Das ME-Signal des Trennschicht-ME-Sensors (obere Graphik) ist etwa um den Faktor 5-6 größer als das ME-Spannungssignal des herkömmlichen Biegebalkensensors im Plattenkondensatordesign (untere Graphik)

Zu den Vorteilen des erfindungsgemäßen Sensordesigns zählen:

1. Es ist möglich, genau wie beim konventionellen Herstellverfahren für Biegebalkensensoren nach Fig. 1, die magnetostriktive Schicht erst nach dem Kristallisieren der ferroelektrischen Schicht auf das Substrat zu bringen. Die angesprochenen Nachteile einer invertierten Schichtfolge treten nicht auf.

2. Die ferroelektrische Schicht hat eine Außenfläche, auf die eine beliebige Elektrodenanordnung aufgebracht werden kann, die den Spannungsabgriff entlang der Schicht ermöglicht. Dies können im einfachsten Fall ein Paar Interdigitalelektroden (IDT) sein, aber auch zwei miteinander kontaktierte IDTs mit einer zwischen deren Fingern verlaufenden, meanderförmigen Gegenelektrode kommen in Frage. Man ist bei der Ausgestaltung jedenfalls sehr frei.

3. Da man den Fingerabstand der Elektroden nach Belieben einrichten kann, hat man nun einen Freiheitsgrad bei der Sensorfertigung, der über einen Bereich von mehreren Größenordnungen je nach Bedarf und Möglichkeiten des Anwenders gewählt werden kann. Im Stand der Technik war der Elektrodenabstand durch den Prozessaufwand der Schichtdickeneinstellung limitiert.

4. Die magnetostriktive Schicht kann als ein Multilagenschichtsystem ausgebildet werden. Vorzugsweise können abwechselnd dünne Lagen (einige Nanometer dick) aus antiferromagnetischem (AFM) und ferromagnetischem (FM) Material mit einem Sputterverfahren aufgebracht werden, die gemäß der - nicht vorveröffentlichten - EP 11 171 354.1 bei geeignetem "field annealing" ein Exchange Bias ausbilden, welches das Vorsehen eines permanentmagnetischen Bias-Magnetfeldes überflüssig macht. AFM/FM-Schichtsysteme sollten jedoch auf möglichst glatten und texturfreien Substraten (z.B. Siliziumwafer) abgeschieden werden. Sie sind auf rauen und unregelmäßig texturierten, keramischen Ferrorelektrika zumindest schwieriger einzurichten, z.B. unter Zuhilfenahme texturlöschender Zwischenschichten. Wenn man bei der Fertigung von Trennschicht-ME-Sensoren die Beschichtung beider Flachseiten desselben Substrats durchführt, ist das Anordnen präziser Multilagenschichtsysteme kein Problem.

An dieser Stelle soll erwähnt werden, dass man den Ansatz der beidseitigen Substratbeschichtung mit den Funktionsschichten eines ME-Sensors natürlich auch für das konventionelle Biegebalkendesign verwenden könnte. Dazu würde man auf die Substratvorderseite zunächst eine flächige Unterelektrode und ein Ferroelektrikum aufbringen, dann darauf eine flächige Oberelektrode und schließlich die magnetostriktive Schicht auf die Substratrückseite. Dieses Design hätte gegenüber dem Stand der Technik den unter Punkt 4 oben beschriebenen Vorteil, und natürlich würde auch Punkt 1 gelten. Eine höhere ME-Spannung würde man allerdings nur erwarten können, wenn man auf diese Weise ein magnetostriktives Schichtsystem mit einem höheren piezomagnetischen Koeffizienten als bislang möglich verwenden kann. Im Übrigen würde man hier generell eine möglichst dünne Trennschicht zwischen Funktionsschichten vorsehen wollen, da bei der Polung des Ferroelektrikums ohnehin keine Spannung über die Trennschicht abfallen kann. Die Trennschicht hat hier eine völlig andere Aufgabe, nämlich die Bereitstellung einer günstig strukturierten Oberfläche. Insofern ordnet sich dieses "nahezu konventionelle" Sensordesign dem zuvor beschriebenen Konzept des erfindungsgemäßen Trennschicht-ME-Sensors, der u. a. durch einen Spannungsabgriff entlang der Schichtenausdehnung charakterisiert ist, nicht unter und wird hier auch nicht beansprucht.

Abschließend sei angemerkt, dass in der vorliegenden Beschreibung die Begriffe "Trägerschicht", "Trennschicht" und "Substrat" alle zur Bezeichnung desselben Materials in einem ME-Sensor benutzt werden und insofern als Synonyme gelten sollen. Die Gründe dafür, dass hier drei Begriffe für einen technischen Gegenstand angeführt werden, sind folgende:

a) Der Begriff "Trennschicht" trifft den Erfindungsgedanken am besten, ist aber dem Fachmann im Bereich ME-Sensoren nicht geläufig. Er soll deshalb in den Ansprüchen nicht verwendet werden.

b) Ein dielektrisches "Substrat" wird bei jedem Dünnschicht-ME-Sensor zwar vorliegen, aber ein Trennschicht-ME-Sensor muss nicht zwingend in Dünnschichttechnik hergestellt werden. Es könnte beispielsweise auch eine freitragende, vorgefertigte ferroelektrische Keramikplatte als ein Substrat verwendet werden. Da man - wie bereits erläutert - die Polung dieser Platte entlang ihrer Ausdehnung erst vornehmen kann, nachdem die magnetostriktive Schicht angeordnet und vorbehandelt worden ist, wird man auch hier eine Trennschicht benötigen, wenn man hohe Spannungen zur Polung nutzt. Diese Trennschicht könnte somit auf die ferroelektrische Platte mit irgendeinem angemessenen Beschichtungsverfahren aufgebracht werden, woraufhin auf die Trennschicht die magnetostriktive Schicht angeordnet wird. Die dielektrische Trennschicht muss also nicht zwingend das Substrat sein, sondern kann auch eigens aufgetragen werden.

c) Wenn man einen beliebigen funktionsfähigen, bereits vereinzelten Dünnschicht-ME-Sensor untersucht (und dabei z.B. aufschneidet), wird man gewöhnlich zwei sehr dünne Funktionsschichten und eine dielektrische Schicht vorfinden, die die beiden Funktionsschichten mechanisch stabilisiert und trägt. Unabhängig davon, ob diese tragende Schicht einstmals das Substrat war oder selbst als Schicht aufgebracht worden ist, wird der Fachmann den Begriff "Trägerschicht" hierfür akzeptieren können.

Bezugszeichenliste

10    ferroelektrische Schicht
12    magnetostriktive Schicht

14   Trägerschicht
16   Unterelektrode
18   Elektrodenanordnung

ME   magnetoelektrischer Sensor
$U_{ME}$   Spannung

**Patentansprüche**

1. Magnetoelektrischer (ME) Sensor umfassend einen Schichtenstapel aus einer magnetostriktiven Schicht (12), einer ferroelektrischen Schicht (10) und einer dielektrischen Trägerschicht (14), **dadurch gekennzeichnet, dass**

   a. die Trägerschicht (14) dicker ist als die ferroelektrische Schicht (10) und
   b. die Trägerschicht (14) zwischen der magnetostriktiven Schicht (12) und der ferroelektrischen Schicht (10) angeordnet ist und
   c. eine Elektrodenanordnung (18) ausgebildet zum Signalspannungsabgriff entlang der Schichtenausdehnung auf der ferroelektrischen Schicht (10) angeordnet ist, wobei
   d. der Fingerabstand der Elektrodenanordnung (18) größer ist als die Dicke der ferroelektrischen Schicht (10).

2. ME-Sensor nach Anspruch 1, **dadurch gekennzeichnet, dass** der Fingerabstand der Elektrodenanordnung (18) größer ist als die Dicke der Trägerschicht (14).

3. ME-Sensor nach Anspruch 1 oder 2, **dadurch gekennzeichnet, dass** die Trägerschicht (14) aus einem Material gebildet ist, das einen Elastizitätsmodul größer als 20 GPa aufweist.

4. ME-Sensor nach Anspruch 1, 2 oder 3, **dadurch gekennzeichnet, dass** die Trägerschicht (14) aus einem Glas, vorzugsweise aus Siliziumdioxid, einer Keramik oder einem Halbleiter, vorzugsweise aus Silizium, gebildet ist.

5. ME-Sensor nach einem der vorangehenden Ansprüche, **dadurch gekennzeichnet, dass** die ferroelektrische Schicht (10) aus Blei-Zirkonat-Titanat (PZT) gebildet ist.

6. ME-Sensor nach einem der vorangehenden Ansprüche, **dadurch gekennzeichnet, dass** die magnetostriktive Schicht (12) aus der Gruppe der amorphen magnetischen Materialien gebildet ist.

7. Verfahren zur Herstellung eines ME-Sensors nach einem der vorangehenden Ansprüche **mit den** Schritten:

   a. Aufbringen eines eine ferroelektrische Schicht (10) bildenden Materials auf die erste Flachseite eines dielektrischen Substrats (14),
   b. Kristallisation des Materials bei Temperaturen über 500°C unter Bildung einer ferroelektrischen Schicht (10), deren Dicke kleiner ist als die vorbekannte Dicke des Substrats (14),
   c. Aufbringen einer Elektrodenanordnung (18) ausgebildet zum Signalspannungsabgriff entlang der Schichtenausdehnung auf die ferroelektrische Schicht (10), wobei der Fingerabstand größer ist als die Dicke der ferroelektrischen Schicht (10),
   d. Aufbringen einer magnetostriktiven Schicht (12) auf die zweite Flachseite des Substrats (14),
   e. Magnetische Polung der magnetostriktiven Schicht (12) bei Temperaturen unter 500°C und
   f. Alternierende elektrische Polung der ferroelektrischen Schicht (10) entlang der Schichtausdehnung bei einer Temperatur unterhalb der Curie-Temperatur der ferroelektrischen Schicht (10).

8. Verfahren nach Anspruch 7, **dadurch gekennzeichnet, dass** die magnetostriktive Schicht (12) als ein Multilagenschichtsystem auf dem Substrat abgeschieden wird.

9. Verfahren nach Anspruch 8, **dadurch gekennzeichnet, dass** die magnetostriktive Schicht (12) mit einander abwechselnden Lagen aus einem antiferromagnetischen und einem ferromagnetischen Material gebildet und einer Temperaturbehandlung in einem vorbestimmten Magnetfeld zur Ausbildung eines Exchange Bias unterzogen wird.

**Claims**

1. A magnetoelectric (ME) sensor comprising a layer stack from a magnetostrictive layer (12), a ferroelectric layer (10), and a dielectric support layer (14),
   **characterised in that**

   a. the support layer (14) is thicker than the ferroelectric layer (10) and
   b. the support layer (14) is arranged between the magnetostrictive layer (12) and the ferroelectric layer (10) and
   c. an electrode arrangement (18), engineered for tapping the signal voltage along the extent of the layer, is arranged on the ferroelectric layer (10),
   d. the finger distance of the electrode arrangement (18) being greater than the thickness of the ferroelectric layer (10).

2. The ME- sensor according to Claim 1, **characterised in that** the finger distance of the electrode arrangement (18) is greater than the thickness of the support layer (14).

3. The ME sensor according to Claim 1 or 2, **characterised in that** the support layer (14) is formed from a material that exhibits a modulus of elasticity of more than 20 GPa.

4. The ME- sensor according to Claim 1, 2 or 3, **characterised in that** the support layer (14) is formed from a glass, preferably from silicon dioxide, a ceramic or a semiconductor, preferably from silicon.

5. The ME- sensor according to one of the preceding claims, **characterised in that** the ferroelectric layer (10) is formed from a lead zirconate titanate (PZT).

6. The ME sensor according to one of the preceding claims, **characterised in that** the magnetostrictive layer (12) is formed from the group of the amorphous magnetic materials.

7. A method for manufacturing an ME sensor according to one of the preceding claims, having the following steps:

   a. applying a material forming a ferroelectric layer (10), on the first flat side of a dielectric substrate (14),
   b. crystallisation of the material at temperatures above 500°C while forming a ferroelectric layer (10), which thickness is smaller than the known thickness of the substrate (14),
   c. applying an electrode arrangement (10), engineered for tapping the signal voltage along the extent of the layer, on the ferroelectric layer (10), the finger distance being greater than the thickness of the ferroelectric layer (10),
   d. applying a magnetostrictive layer (12) on the second flat side of the substrate (14),
   e. magnetic poling of the magnetostrictive layer (12) at temperatures below 500°C, and
   f. alternating electric poling of the ferroelectric layer (10) along the extent of the layer at a temperature below the Curie temperature of the ferroelectric layer (10).

8. The method according to Claim 7, **characterised in that** the magnetostrictive layer (12) is deposited on the substrate as a multi-layer stack system.

9. The method according to Claim 8, **characterised in that** the magnetostrictive layer (12) is formed from alternating layers from an antiferromagnetic and a ferromagnetic material and is subjected to temperature treatment in a predetermined magnetic field to form an exchange bias.

**Revendications**

1. Capteur magnéto-électrique (ME) comprenant un empilement de couches composé d'une couche magnétostrictive (12), une couche ferroélectrique (10) et une couche support diélectrique (14),
   **caractérisé en ce que**

   a. la couche support (14) est plus épaisse que la couche ferroélectrique (10) et
   b. la couche support (14) est disposée entre la couche magnétostrictive (12) et la couche ferroélectrique (10) et
   c. un assemblage d'électrodes (18), conçu pour prélever le courant de signal le long de l'étendue de la couche, est disposé sur la couche ferroélectrique (10),

d. la distance inter-électrodes de l'assemblage d'électrodes (18) est supérieure à l'épaisseur de la couche ferroélectrique (10).

2. Capteur ME selon la revendication 1, **caractérisé en ce que** la distance inter-électrodes de l'assemblage d'électrodes (18) est supérieure à l'épaisseur de la couche support (14).

3. Capteur ME selon la revendication 1 ou 2, **caractérisé en ce que** la couche support (14) est réalisée dans un matériau qui présente un module d'élasticité supérieur à 20 GPa.

4. Capteur ME selon la revendication 1, 2 ou 3, **caractérisé en ce que** la couche support (14) est en verre, de préférence en dioxyde de silicium, en une céramique ou en un matériau semi-conducteur, de préférence en silicium.

5. Capteur ME selon l'une des revendications précédentes, **caractérisé en ce que** la couche ferroélectrique (10) est réalisée en titano-zirconate de plomb (PZT).

6. Capteur ME selon l'une des revendications précédentes, **caractérisé en ce que** la couche magnétostrictive (12) est réalisée dans un matériau du groupe des matériaux magnétiques amorphes.

7. Procédé pour la fabrication d'un capteur ME selon l'une des revendications précédentes, aves les étapes suivantes :

a. Application sur la première face plane d'un substrat diélectrique (14) d'un matériau formant une couche ferroélectrique (10),

b. Cristallisation du matériau à des températures supérieures à 500 °C en formant une couche ferroélectrique (10) dont l'épaisseur est inférieure à l'épaisseur préalablement connue du substrat (14),

c. Application sur la couche ferroélectrique (10) d'un assemblage d'électrodes (18) conçu pour prélever le courant de signal le long de l'étendue de la couche, la distance inter-électrodes étant supérieure à l'épaisseur de de la couche ferroélectrique (10),

d. Application d'une couche magnétostrictive (12) sur la deuxième face plane du substrat (14)

e. Polarisation magnétique de la couche magnétostrictive (12) à des températures inférieures à 500 °C, et

f. Polarisation électrique alternative de la couche ferroélectrique (10) le long de l'étendue de la couche à une température inférieure à la température de Curie de la couche ferroélectrique (10).

8. Procédé selon la revendication 7, **caractérisé en ce que** la couche magnétostrictive (12) est déposée sur le substrat sous la forme d'un système multicouche.

9. Procédé selon la revendication 8, **caractérisé en ce que** la couche magnétostrictive (12) est formée par des couches successives d'un matériau antiferromagnétique et d'un matériau ferromagnétique et est soumise à un traitement thermique dans un champ magnétique prédéfini en vue de former une polarisation d'échange.

Stand der Technik

Fig. 1

10

$U_{ME}$

18

14

12

Fig. 2

Fig. 3

**IN DER BESCHREIBUNG AUFGEFÜHRTE DOKUMENTE**

**In der Beschreibung aufgeführte Patentdokumente**

- US 20080193780 A1
- US 20070252593 A1
- EP 11171354 A
- EP 2538235 A1

**In der Beschreibung aufgeführte Nicht-Patentliteratur**

- **H. GREVE ; E. WOLTERMANN ; H.-J. QUENZER ; B. WAGNER ; E. QUANDT.** Giant magnetoelectric coefficients in (Fe90Co10)78Si12B10-AIN thin film composites. *Applied Physics Letters,* 2010, vol. 96, 182501